# EUROPÄISCHE PATENTSCHRIFT

(11) **EP 1 526 612 B1**
(45) Veröffentlichungstag und Bekanntmachung des Hinweises auf die Patenterteilung: **15.12.2010**
(21) Anmeldenummer: 04024329.7
(22) Anmeldetag: 13.10.2004
(51) Int. Cl.: H01R 12/20, H01R 13/658

(54) **Schirmanschlusseinrichtung für eine in einem Gehäuse angeordnete Leiterplatte**
Shielded connecting arrangement for a printed circuit board arranged in a housing
Dispositif de connexion blindé pour un circuit imprimé disposé dans un boîtier

(30) Priorität: 23.10.2003 DE 20316262 U
(43) Veröffentlichungstag der Anmeldung: 27.04.2005
(73) Patentinhaber: PHOENIX CONTACT GmbH & Co. KG, 32825 Blomberg (DE)
(72) Erfinder: Beckmann, Ralf, Dipl.-Ing., 32758 Detmold (DE); Lohr, Markus, 33039 Nieheim (DE); Feye-Hohmann, Jürgen, 32756 Detmold (DE); Henkel, Jens-Uwe, 32756 Detmold (DE)
(74) Vertreter: Schober, Mirko

(56) Entgegenhaltungen:
- US-A- 5 254 010
- US-A- 5 356 313
- US-A- 5 695 362
- US-A1- 2003 109 151
- US-B1- 6 210 220
- US-B1- 6 386 910

## Beschreibung

Die Erfindung bezieht sich auf eine Schirmanschlußeinrichtung für eine in einem Gehäuse angeordnete Leiterplatte mit einem außenseitig an einer Gehäusewand mittels Befestigungsschrauben festlegbaren Steckerteil, das mit einem Buchsenteil innenseitig an der Gehäusewand durch einen Wandausschnitt hindurch kuppelbar ist und das einen in elektrischem Kontakt mit den Befestigungsschrauben stehenden Schirmanschluß zur Anbindung eines Schirms eines an das Steckerteil angeschlossenen Kabels aufweist, dessen elektrische Leitungen über das Steckerteil und das Buchsenteil an der Leiterplatte anschließbar sind.

In bekannter Ausführung einer solchen Schirmanschlußeinrichtung erfolgt die Überleitung des Schirmpotentials auf die betreffende Leiterbahn der Leiterplatte über die metallenen Gehäuse des Steckerteils und des Buchsenteils. Die Befestigungsschrauben zur Sicherung des Steckerteils an der betreffenden Gehäusewand greifen hierbei in Gewindebuchsen ein, die Teil einer aus Metall bestehenden Gehäusewand sein können, die an sich noch nicht in einem unmittelbaren elektrisch leitenden Kontakt mit der das Schirmpotential führenden Leiterbahn der Leiterplatte steht. Für die Kontaktierung dieser Leiterbahn der Leiterplatte, um sie mit dem Kabelschirm des am Steckerteil angeschlossenen Kabels leitend zu verbinden, müssen folglich besondere Hilfseinrichtungen vorgesehen werden.

Aus dem Dokument US 6,210,220 B1 ist ein elektrischer Steckverbinder bekannt, der zur Anordnung auf einer Leiterplatte vorgesehen ist. Er weist ein Isoliergehäuse auf, an dem mittels Befestigungsschrauben eine Frontplatte festgelegt werden kann. Dazu dienen in Aussparungen des Isoliergehäuses einsetzbare Sicherungsbleche mit Gewindeöffnungen, und diese Sicherungsbleche sind mit nach unten aus dem Isoliergehäuse hervorstehenden Federbeinen versehen, die in Befestigungslöcher der Leiterplatte eingreifen.

Aus dem Dokument US 5,695,362 ist ein ebenfalls auf eine Leiterplatte aufsetzbarer Steckverbinder bekannt, der mit einem Buchsenteil versehen ist, welches durch einen Wanddurchbruch einer Gehäusewand hindurchragt. Ferner sind ein Schirmpotential übertragende Kontakte vorhanden, zu denen eine Kontaktschiene mit Federkontakten gehört, die zumindest eine Leiterbahn der Leiterplatte kontaktieren.

Aufgabe der vorliegenden Erfindung ist es, für eine Schirmanschlußeinrichtung der eingangs genannten Art zwischen den Befestigungsschrauben des Steckerteils und der zum Führen des Schirmpotentials vorgesehenen Leiterbahn der Leiterplatte Kontaktelemente vorzusehen, die einfach herzustellende, kontaktsichere und robuste Bauteile sind.

Diese Aufgabe wird bei einer Schirmanschlußeinrichtung gemäß Anspruch 1 gelöst.

Die erfindungsgemäßen Schirmbleche lassen sich als einfache Stanzteile leicht herstellen. Auch das Einpressen oder Einschneiden der Gewindebuchse im Befestigungsflansch der Schirmbleche erfordert keinen großen Aufwand. Das Verspannen der Schirmbleche über den Befestigungsflansch an der betreffenden Gehäusewand mittels der Befestigungsschrauben des Steckerteils sorgt für eine gute Befestigung sowie eine erschütterungssichere Kontaktierung zur Überleitung des Schirmpotentials vom Steckerteil auf das jeweilige Schirmblech oder in umgekehrter Richtung. Ebenso sicher ist die Kontaktierung zwischen dem jeweiligen Schirmblech und der betreffenden Leiterbahn der Leiterplatte mittels zumindest einem, vorteilhaft jedoch zweier oder dreier einlötbarer Stifte, über die zugleich die mechanische Befestigung der Schirmbleche an der Leiterplatte erfolgt.

Vorteilhafte Ausgestaltungsmerkmale der Erfindung ergeben sich aus den Unteransprüchen.

Die Erfindung wird nachfolgend anhand der Zeichnung an einem Ausführungsbeispiel noch näher erläutert. Dabei zeigen:
- Fig. 1: eine Steckverbinder-Anschlußvorrichtung an einer Leiterplatte, die in einem teilweise dargestellten Gehäuse angeordnet ist, in der Seitansicht,
- Fig. 2: eine perspektivische Ansicht der Steckanschlußeinrichtung gem. Fig. 1 von der Gehäuseinnenseite aus gesehen und
- Fig. 3: eine perspektivische Darstellung des Schirmblechs der Schirmanschlußeinrichtung für eine Steckverbinder-Anschlußvorrichtung nach den Figuren 1 und 2.

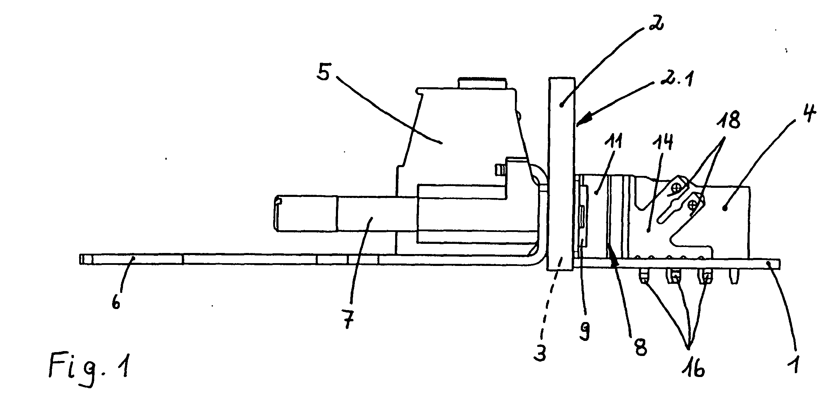

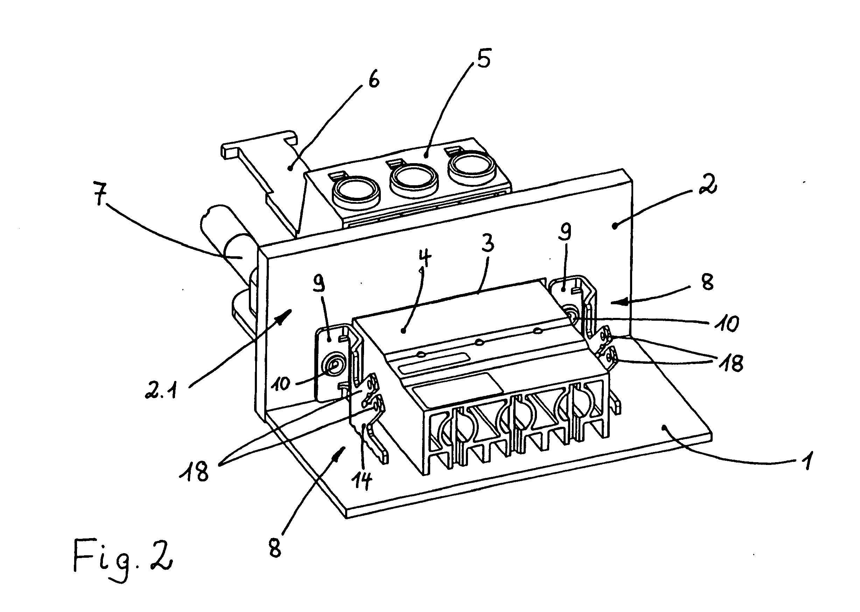

Im einzelnen zeigen die Figuren 1 und 2 schematisch eine Leiterplatte 1, die rechtwinklig an eine Gehäusewand 2 angrenzt. In der Gehäusewand 2 befindet sich ein Durchbruch 3, durch den hindurch ein Buchsenteil 4, welches im Gehäuseinnern angeordnet ist, und ein Steckerteil 5 miteinander in Eingriff gebracht werden können. Das Steckerteil 5 ist an ein in der Zeichnung nicht dargestelltes Kabel angeschlossen, dessen elektrische Leitungen über das Steckerteil 5 und das Buchsenteil 4 an die betreffenden Kontaktpositionen der Leiterplatte 1 angeschlossen werden können. Kabel dieser Art weisen einen Kabelschirm auf, der an einen Schirmanschluß 6 am Steckerteil 5 sowohl mechanisch als auch elektrisch angebunden wird. Die Sicherung des an das Buchsenteil 4 angekuppelten Steckerteils 5 erfolgt mittels Befestigungsschrauben 7, die in elektrisch leitender Verbindung mit dem Schirmanschluß 6 stehen.

Zu beiden Seiten des Buchsenteils 4 finden sich Schirmbleche 8, wobei das am Buchsenteil 4 links nach Fig. 2 angeordnete Schirmblech 8 und das am Buchsenteil 4 rechts angeordnete Schirmblech 8 identisch sind. Zum einen sitzen beide Schirmbleche 8 fest an der Leiterplatte 1 und zum anderen sind sie in der Einbaulage gegen die Innenseite 2.1 der Gehäusewand 2 fest verspannt. Dazu weist jedes der Schirmbleche 8 einen Befestigungsflansch 9 auf, in den eine Gewindebuchse 10 eingeschnitten, eingeprägt oder eingesetzt ist. Diese Gewindebuchse 10 ist für den Eingriff der Befestigungsschrauben 7 am Steckerteil 5 bestimmt.

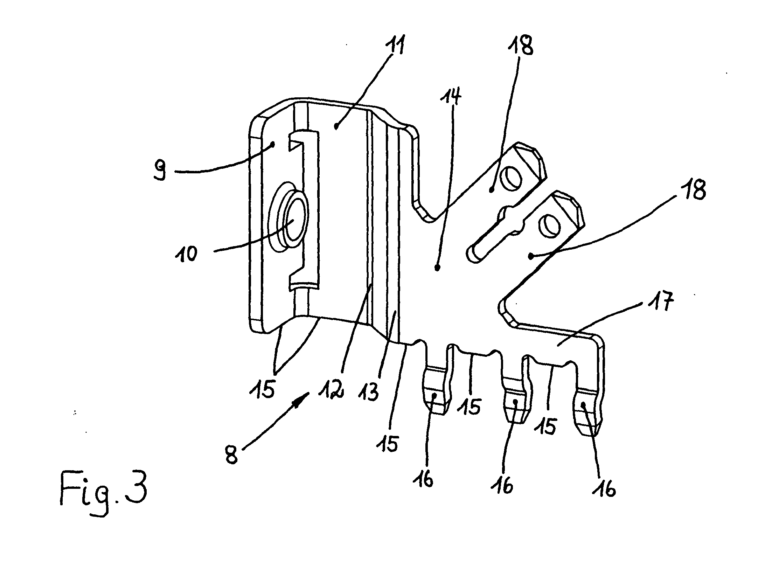

Die Einzelheiten eines solchen Schirmbleches 8 zeigt Fig. 3. An dessen Befestigungsflansch 9 mit der Gewindebuchse 10 schließt rechtwinklig ein Flachsteg 11 an, der über eine erste Kröpfung 12 und eine zweite Kröpfung 13 in ein plattenförmiges Anschlußteil 14 übergeht, welches eine etwa dreieckförmige Grundform aufweist. Damit das Schirmblech 8 sicher auf die jeweilige Leiterplatte 1 aufgesetzt werden kann, besteht dessen untere Schmalseite aus sich über den Befestigungsflansch 9, den Flachsteg 11 und das plattenförmige Anschlußteil 14 fortsetzenden Kanten 15, die sämtlich in einer gemeinsamen Ebene liegen. Die Kröpfungen 12 und 13 zwischen dem Flachsteg 11 und dem plattenförmigen Anschlußteil 14 sind derart, daß das plattenförmige Anschlußteil 14 parallel zum Flachsteg 11 liegt und somit ebenfalls senkrecht zum Befestigungsflansch 9 steht. Dabei liegt die Ebene des plattenförmigen Anschlußteils 14 in der Flucht der Gewindeachse der Gewindebuchse 10.

An dem plattenförmigen Anschlußteil 14 sind über dessen Unterkanten 15 vorstehend Lötpins oder -stifte 16 ausgebildet, die miteinander parallel sind und sich im wesentlichen in Richtung der Ebene des plattenförmigen Anschlußteils 14 erstrecken. Über die Unterkanten 15 des Anschlußteils 14 stehen die Lötstifte 16 senkrecht vor, wobei nur einer der drei vorhandenen Lötstifte 16 an das im wesentlichen dreieckförmige Anschlußteil 14 anschließt. Die beiden weiteren Lötstifte 16 sitzen an einem Arm 17, der sich in Verlängerung einer der Dreiecksseiten des Anschlußteils 14 in Richtung vom Befestigungsflansch 9 weg erstreckt. An dem zentralen Anschlußteil 14 schließen noch zwei Flachsteckanschlußzungen 18 an, die miteinander parallel sind und die in einer Richtung vom Anschlußteil 14 weg vorstehen, die von den Lötstiften 16 weg, vornehmlich nach oben hin weist.

Die Leiterplatte 1 (Figuren 1 und 2) weist entsprechend der Anordnung der Lötstifte 16 an den Schirmblechen 8 Durchgangslöcher auf, in welche die Lötstifte 16 eingesteckt und durch Verlöten nicht nur elektrisch kontaktiert sondern auch mechanisch gesichert werden können. Die besondere Ausrichtung des zentralen, plattenförmigen Anschlußteils 14 relativ zum Befestigungsflansch 9 und der Gewindebuchse 10 macht es möglich, das Sicherungsblech 8 in ein und derselben Ausführung sowohl rechtsseitig als auch linksseitig des Buchsenteils bzw. des Steckerteils verwenden zu können, womit sich zwei unterschiedliche, zueinander spiegelbildliche Ausführungen erübrigen.

## Patentansprüche

1. Schirmanschlußeinrichtung für eine in einem Gehäuse angeordnete Leiterplatte (1) mit einem außenseitig an einer Gehäusewand (2) mittels Befestigungsschrauben (7) festlegbaren Steckerteil (5), das mit einem Buchsenteil (4) innenseitig an der Gehäusewand (2) durch einen Wanddurchbruch (3) hindurch kuppelbar ist und das einen in elektrischem Kontakt mit den Befestigungsschrauben (7) stehenden Schirmanschluß (6) zur Anbindung eines Schirms eines an das Stekkerteil (5) angeschlossenen Kabels aufweist, dessen elektrische Leitungen über das Steckerteil (5) und das Buchsenteil (4) an der Leiterplatte (1) anschließbar sind, wobei an der Leiterplatte (1) fest ansetzbare, mit deren zumindest einer Leiterbahn für den Anschluß des Schirmpotentials in Kontakt bringbare Schirmbleche (8) vorgesehen sind, die je einen Befestigungsflansch (9) zur Anlage an der Innenseite (2.1) der Gehäusewand (2) und in dem Befestigungsflansch (9) eine Gewindebuchse (10) für den Eingriff einer der Befestigungsschrauben (7) des Steckerteils (5) aufweisen, wobei jedes Schirmblech (8) ein rechtwinklig zum Befestigungsflansch (9) stehendes, plattenförmiges Anschlußteil (14) aufweist, welches mittels Kröpfungen (12, 13) in einen Flachsteg (11) übergeht, der rechtwinklig an den Befestigungsflansch (9) anschließt, und wobei die Schirmbleche (8) untere, sich über den Befestigungsflansch (9), den Flachsteg (11) und das plattenförmige Anschlußteil (14) fortsetzende Aufstandskanten (15) aufweisen, die sämtlich in einer gemeinsamen Ebene liegen, über die zumindest ein Lötstift (16) senkrecht vorsteht, der in Fortsetzung der Plattenebene an das plattenförmige Anschlußteil (14) anschließt.

2. Schirmanschlußeinrichtung nach Anspruch 1,
**dadurch gekennzeichnet,**
**daß** zwei oder mehrere Lötstifte (16) an dem Anschlußteil (14) der Schirmbleche (8) vorhanden sind, die parallel miteinander ausgerichtet sind.

3. Schirmanschlußeinrichtung nach Anspruch 1 oder 2,
**dadurch gekennzeichnet,**
**daß** der zumindest eine Lötstift (16) sich senkrecht zur Achsrichtung der Gewindebuchse (10) im Befestigungsflansch (9) der Schirmbleche (8) erstreckt.

4. Schirmanschlußeinrichtung nach einem der Ansprüche 1 - 3,
**dadurch gekennzeichnet,**
**daß** am Befestigungsflansch (9) und/oder dem Anschlußteil (14) zumindest eine Flachsteckanschlußzunge (18) ausgebildet ist, die sich in einer von der Anschlußrichtung des zumindest einen Lötstiftes (16) wegweisenden Richtung erstreckt.

5. Schirmanschlußeinrichtung nach einem der Ansprüche 1 - 4,
**dadurch gekennzeichnet,**
**daß** der Flachsteg (11) rechtwinklig sowie in gleicher Höhe an dem Befestigungsflansch (9) anschließt und das plattenförmige Anschlußteil (14) parallel zum Flachsteg (11) sowie fluchtend mit der Achse der Gewindebuchse (10) ausgerichtet ist.

## Claims

1. Shield connecting device for a conductor plate (1) mounted in a housing and having a plug part (5) which is fixable on the outside of a housing wall (2) by means of fixing screws (7) and which can be coupled to a socket part (4) on the inside of the housing wall (2) through an aperture (3) in the wall and which has a shield connector (6) which is in electrical contact with the fixing screws (7) for connecting a shield of a cable attached to the plug part (5) whose electric leads are connectable to the conductor plate (1) by the plug part (5) and the socket part (4) wherein shield plates (8) are provided which can be fixedly attached to the conductor plate (1) and brought into contact with the at least one circuit path for connecting the shield potential wherein the shield plates each have a fastening flange (9) for bearing against the inside (2.1) of the housing wall (2) and in the fastening flange (9) a threaded bush (10) for the engagement of one of the fixing screws (7) of the plug part (5) wherein each shield plate (8) has a plate-type connector part (14) which is at right angles to the fastening flange (9) and by means of angle bends (12, 13) changes into a flat web (11) which adjoins the fastening flange (9) at right angles, and wherein the shield plates (8) have lower upstanding edges (15) which project beyond the fastening flange (9), the flat web (11) and the plate-like connector part (14) and which all lie in a common plane, beyond which at least one solder pin (16) projects perpendicularly to adjoin the plate-like connector part (14) in a projection of the plate plane.

2. Shield connecting device according to claim 1 **characterised in that** two or more solder pins (16) are provided on the connector part (14) of the shield plates (8) which are aligned parallel with one another.

3. Shield connecting device according to claim 1 or 2 **characterised in that** the at least one solder pin (16) extends perpendicularly to the axial direction of the threaded bush (10) in the fastening flange (9) of the shield plates (8).

4. Shield connecting device according to one of claims 1 to 3 **characterised in that** on the fastening flange (9) and/or the connector part (14) at least one flat plug connector tongue (18) is formed which extends in a direction pointing away from the connecting direction of the at least one solder pin (16).

5. Shield connecting device according to one of claims 1 to 4 **characterised in that** the flat web (11) adjoins the fastening flange (9) both at right angles and at the same height and the plate-like connector part (14) is aligned parallel to the flat web (11) and flush with the axis of the threaded bush (10).

## Revendications

1. Dispositif de connexion blindé pour une plaquette de circuit imprimé (1), qui, disposé dans un boîtier, comprend une fiche mâle (5) fixable, à l'extérieur, sur une paroi (2) du boîtier au moyen de vis de fixation (7), et pouvant être couplée avec une fiche femelle (4), sur la face intérieure de la paroi (2) du boîtier, à travers un jour (3) pratiqué dans ladite paroi, et qui présente un raccord (6) en contact électrique avec les vis de fixation (7), pour le raccordement du blindage d'un câble relié à la fiche mâle (5), dont les conducteurs électriques peuvent être reliés à la plaquette de circuit imprimé (1) par l'intermédiaire de la fiche mâle (5) et de la fiche femelle (4), des tôles de blindage (8), qui, fixables sur la plaquette de circuit imprimé (1), peuvent être mises en contact avec au moins une piste conductrice de celle-ci, étant prévues pour la connexion du potentiel du blindage, chacune de ces tôle de blindage présentant une bride de fixation (9), destinée à porter contre la face intérieure (2.1) de la paroi (2) du boîtier, et une douille filetée (10) étant prévue dans la bride de fixation (9) pour l'insertion de l'une des vis de fixation (7) de la fiche mâle (5), chaque tôle de blindage (8) présentant une pièce de raccordement (14) en forme de plaque, qui, faisant saillie à angle droit par rapport à la bride de fixation (9), se fond, en passant par des parties coudées (12, 13), en une plaque plane (11), qui se raccorde à angle droit à la bride de fixation (9), et les tôle de blindage (8) présentant des bords d'appui (15) inférieurs, qui, en prolongement de la bride de fixation (9), de la plaque médiane plane (11) et de la pièce de raccordement en forme de plaque (14), sont tous disposés sur un plan commun, au-delà duquel au moins une borne de brasage (16) fait saillie verticalement et se raccorde, en prolongement du plan de la plaque, à la pièce de raccordement en forme de plaque (14).

2. Dispositif de connexion blindé selon la revendication 1,
**caractérisé en ce que**
deux ou plusieurs bornes de brasage (16), disposées parallèlement les uns par rapport aux autres, sont prévues sur la pièce de raccordement (14) de la tôle de blindage (8).

3. Dispositif de connexion blindé selon revendication 1 ou 2,
**caractérisé en ce que**
la borne de brasage (16) au moins prévue s'étend perpendiculairement à la direction axiale de la douille filetée (10), dans la bride de fixation (9) de la tôle de blindage (8).

4. Dispositif de connexion blindé selon l'une des revendications 1 à 3,
**caractérisé en ce que**,
sur la bride de fixation (9) et / ou sur la pièce de raccordement (14), est formée au moins une languette de raccordement plate (18), qui s'étend dans une direction opposée à la direction de raccordement de la borne de brasage (16) au moins prévue.

5. Dispositif de connexion blindé selon l'une des revendications 1 à 4,
**caractérisé en ce que**
la pièce médiane plane (11) se raccorde, à angle droit ainsi qu'à la même hauteur, à la bride de fixation (9), et que la pièce de raccordement (14) en forme de plaque est orientée parallèlement à la pièce médiane plane (11) ainsi qu'en alignement avec l'axe de la douille filetée (10).
